# EUROPÄISCHE PATENTSCHRIFT

(11) **EP 0 334 108 B1**
(45) Veröffentlichungstag und Bekanntmachung des Hinweises auf die Patenterteilung: **07.12.1994**
(21) Anmeldenummer: 89104113.9
(22) Anmeldetag: 08.03.1989
(51) Int. Cl.: G01S 5/14, H03L 7/08, H04B 1/66

(54) **Empfänger für bandgespreizte Signale, insbesondere GPS-Empfänger**
Receiver for spread-spectrum signals, especially a GPS-type receiver
Récepteur pour signaux à spectre étalé, notamment récepteur du type GPS

(30) Priorität: 12.03.1988 DE 3808328
(43) Veröffentlichungstag der Anmeldung: 27.09.1989
(73) Patentinhaber: Alcatel SEL Aktiengesellschaft, D-70435 Stuttgart (DE)
(72) Erfinder: Wolf, Michael, D-7070 Schwäbisch Gmünd (DE); Beier, Wolfgang, D-7252 Weil der Stadt (DE)
(74) Vertreter: Brose, Gerhard, Dipl.-Ing.

(56) Entgegenhaltungen:
- EP-A- 0 169 520
- DE-A- 3 601 576
- GB-A- 1 502 253
- TECHNIQUES ET PROCEDES NOUVEAUX, COMMUNICATION, Band 5, November 1977, Seiten 127-134, Paris, FR; C.R. CAHN et al.: "La conception d'un récepteur de navigation à spectre étalé"
- IEEE TRANSACTIONS ON COMMUNICATIONS, Band COM-30, Nr. 10, Oktober 1982, Seiten 2285-2288, New York, US; A.H. MAKARIOS et al.: "False-lock performance improvement in costas loops"
- IEE PROCEEDINGS, Teil F, Band 127, Nr. 2, April 1980, Seiten 163-167, London,GB; P.K. BLAIR et al.: "Receivers for the NAVSTAR global positioning system"

## Beschreibung

Die Erfindung betrifft einen Empfänger für bandgespreizte Signale nach dem Oberbegriff des Hauptanspruchs. Ein solcher Empfänger ist, wenn auch nicht für das Global Positioning System GPS bestimmt, aus der DE-PS (DE-C1) 20 48 056 bekannt. Weitere Beispiele solcher Empfänger sind bekannt aus TECHNIQUES ET PROCEDES NOVEAUX, COMMUNICATION, Band 5, November 1977, Seiten 127-134, Paris, FR; C.R. CAHN et al: "La conception d'un récepteur de navigation à spectrale étalé" und DE-A-3 601 576.

Empfänger für bandgespreizte Signale müssen so ausgelegt sein, daß sie die zu empfangenden Signale auch dann aufnehmen können, wenn diese stark verrauscht sind oder sogar im Rauschen untergehen. Dort, wo das Signal ausgewertet wird, also nach der Demodulation mit Hilfe des zur Bandspreizung verwendeten Kodes, soll es deshalb möglichst schmalbandig sein, um möglichst wenig Rauschen zu enthalten. Je schmalbandiger aber ein Empfänger ist, desto schwieriger ist es, bei Frequenzabweichungen das zu empfangende Signal zu finden. Der Fangbereich eines Phasenregelkreises beispielsweise ist direkt proportional zu seiner Bandbreite.

Bandgespreizte Signale werden häufig im militärischen Bereich oder im Satellitenfunk verwendet, wo aufgrund größerer Relativgeschwindigkeiten zwischen Sender und Empfänger eine Dopplerverschiebung der Frequenz auftritt, die deutlich größer ist als die gewünschte Empfängerbandbreite. Der Empfänger muß deshalb zunächst, vorzugsweise nach einer automatisch ablaufenden Suchstrategie, auf die aktuelle Frequenz abgestimmt werden. Wegen der erforderlichen schmalen Bandbreite (Größenordnung 1Hz) darf diese Abstimmung aber nicht sehr schnell erfolgen und bleibt dann möglicherweise sogar hinter der Änderungsgeschwindigkeit der Dopplerverschiebung zurück.

Beim Global Positioning System GPS sollen insgesamt 18 Satelliten ein gleichmäßiges Netz um die Erde bilden und auf einer gemeinsamen Frequenz, jedoch mit verschiedenen Kodes zu Navigationszwecken Signale aussenden. Aus den Signalen von jeweils vier dieser Satelliten, die aus möglichst unterschiedlichen Richtungen empfangen werden, kann einerseits die gemeinsame Systemzeit und andererseits die Position in drei Koordinaten bestimmt werden. Das GPS ist sehr ausführlich in Navigation: Journal of the Institute of Navigation, Band 25, Nr. 2, Sommer 1978, Seiten 121 bis 146, von J.J. Spilker jr. unter dem Titel "GPS Signal Structure and Performance Characteristics" beschrieben.

Zum Empfang von vier Satelliten können zwar vier getrennte Empfänger verwendet werden, es kann aber auch ein einzelner Empfänger verwendet werden, der der Reihe nach die vier Satelliten empfängt. Das Problem der Abstimmzeit verschärft sich dabei aber noch. Es kann zwar dadurch etwas gemildert werden, daß die jeweils zuletzt ermittelten Werte oder daraus extrapolierte Werte voreingestellt werden. Beispielsweise bei der Inbetriebnahme oder beim Austritt aus einem Funkschatten tritt das Problem aber wieder in voller Schärfe auf.

Der Erfindung liegt die Aufgabe zugrunde, einen Empfänger zu schaffen, der schnell auf die jeweils aktuelle Frequenz eingeregelt ist.

Die Aufgabe wird gelöst durch einen Empfänger nach der Lehre des Hauptanspruchs. Weitere Ausgestaltungen der Erfindung sind den Unteransprüchen zu entnehmen.

Die Erfindung nützt einerseits die auch in der eingangs genannten DE-PS 20 48 056 erwähnte Tatsache, daß Frequenz und Phase des Kodes schneller zu finden sind als Frequenz und Phase des Trägers, und andererseits die Tatsache, daß Änderungen der Frequenz, insbesondere durch Dopplerverschiebung, sich beim Träger und beim Kode gleichartig auswirken.

Beim GPS werden in den Sendern die beiden Frequenzen jeweils von einem gemeinsamen Frequenznormal abgeleitet. Werden nun auch im Empfänger beide Frequenzen mit demselben Referenzoszillator verglichen, so ergibt sich daraus ein sehr gutes Einschwingverhalten. Es kann also auch noch mit einem Referenzoszillator geringerer Güte ein zufriedenstellendes Ergebnis erzielt werden.

Erfolgt die Gewinnung von Frequenz und Phase des Trägers in einer sehr tiefen Zwischenfrequenzlage (Null-ZF), so kann ein großer Teil der Signalverarbeitung durch einen programmgesteuerten digitalen Signalverarbeitungsschaltkreis erfolgen. Damit kann insgesamt mit verhältnismäßig geringem Aufwand ein sehr hochwertiger Empfänger realisiert werden.

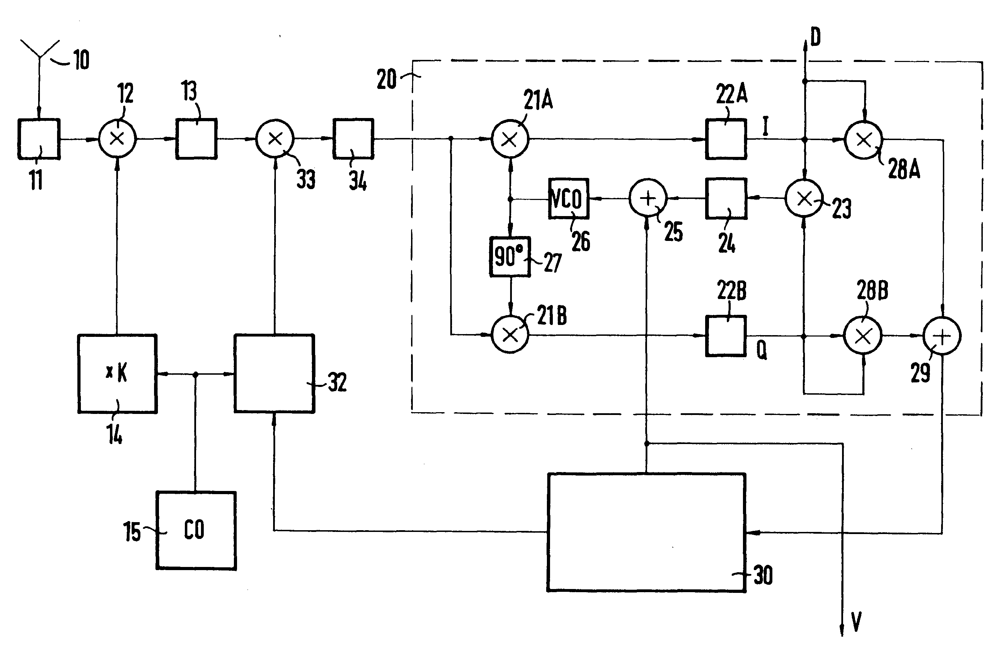

Die Erfindung wird nun anhand eines Ausführungsbeispiels unter Zuhilfenahme der beiliegenden Zeichnung weiter erläutert.

Die Zeichnung zeigt das Blockschaltbild eines erfindungsgemäßen Empfängers. Es ist beispielsweise anhand der DE-OS 34 27 058 oder DE-OS 36 01 576 ohne weiteres möglich, dieses Blockschaltbild teilweise durch eine programmgesteuerte digitale Signalverarbeitung zu realisieren.

Das von einer Antenne 10 kommende Eingangssignal gelangt über einen selektiven Vorverstärker 11, einen Empfangsmischer 12, einen selektiven Verstärker 13, einen Synchrondemodulator 33 und einen Bandpaß 34 zu einem Träger-Phasenregelkreis 20.

Der Träger-Phasenregelkreis 20 liefert einerseits die dem Signal durch Phasenumtastung um 180 Grad (gleichbedeutend mit einer Amplitudenumtastung) aufmodulierten Daten D und andererseits eine dem Betragsquadrat der Signalamplitude proportionale Größe, die mit Hilfe eines Kode-Phasenregelkreises zum Maximum gemacht werden soll. Der Kode-Phasenregelkreis enthält einerseits den Träger-Phasenregelkreis 20, andererseits eine Regeleinrichtung 30, einen Kode-Generator 32 und den bereits genannten Synchrondemodulator 33 mit nachfolgendem Bandpaß 34.

Der Kode-Generator 32 liefert im Takt eines quarzgesteuerten Referenzoszillators 15 (cristal oscillator, CO) ein Kodesignal, das dem Kode entspricht, mit dem das zu empfangende Signal zur Senderkennung und Bandspreizung moduliert ist. Im Falle des GPS werden zwei Kodes pro Sender verwendet, mit denen der Träger des Senders in der Phase jeweils um 180 Grad umgetastet wird. Der Träger kann vom zweiten Kode in solchen Phasenlagen umgetastet werden, die gegen denjenigen um 90° versetzt sind, in denen der Träger vom ersten Kode umgetastet werden kann. Der hier ausgewertete Kode, der in Phase mit dem Träger ist, hat eine Länge von 1023 Bit und eine Taktfrequenz von 1,023 MHz und damit eine Kode-Wiederholfrequenz von 1kHz. Stimmen am Synchrondemodulator Frequenz, Phase und Bitfolge des empfangenen Kodes mit dem im Kode-Generator 32 erzeugten Kode überein, so wird die Modulation dadurch wieder rückgangig gemacht. Das bandgespreizte Signal wird wieder schmalbandig und kann den Bandpaß 34 passieren, während die nicht demodulierten Signale von sendern, die auf derselben Frequenz empfangen werden, wegen der Bandspreizung den Bandpaß 34 nicht passieren können. Außerdem ist ihre Amplitude wegen der fehlenden Demodulation im zeitlichen Mittel gleich Null.

Da der Kode-Generator 32 von einem quarzgesteuerten Oszillator getaktet wird, ist seine Frequenz an sich nicht beeinflußbar. Die Phase kann jedoch durch die Regeleinrichtung 30 verändert werden, indem einzelne Takte hinzugefügt oder unterdrückt werden. Eine nicht nur einmalige, sondern laufende Phasenänderung ist aber einer Frequenzänderung gleichwertig. Diese Frequenzänderung, die in erster Näherung (d.h., wenn die Frequenz des Referenzoszillators und die gesendete Frequenz fehlerfrei sind) der Dopplerverschiebung und damit der relativen Geschwindigkeit zwischen Sender und Empfänger proportional ist, wird in der Regeleinrichtung 30 ermittelt und als Signal v zur Auswertung ausgegeben. Dieses Signal v wird außerdem dem Träger-Phasenregelkreis 20 als die erfindungsgemäße zusätzliche Regelgröße zugeführt.

Die Regeleinrichtung 30 ist so ausgeführt, daß der gesamte Kode-Phasenregelkreis die Eigenschaften eines als Delta-Loop oder Tau-Dither-Loop bekannten Regelkreises hat. Solche Regelkreise werden verwendet, wenn zwischen zwei gleichen, aber gegeneinander phasenverschiebbaren Kodes Phasengleichheit erzielt werden soll. Sind die Kodes Zufalls- oder Pseudozufallsfolgen (PRN = Pseudo Random Noise) oder gar Barker-Kodes, so ergibt sich nur dann ein für die Regelung verwertbares Signal, wenn die Abweichung nicht mehr als ein Bit beträgt. Außerdem ist die Richtung einer Abweichung nicht direkt erkennbar. Beispiele zur Realisierung solcher Regelkreise sind in dem bereits erwähnten Artikel von J.J. Spilker jr. enthalten.

Die Phasenumtastungen bleiben (wie jede Modulation) bei einer Frequenzumsetzung durch Mischung erhalten. Die Auswertung kann deshalb in jeder Frequenzlage erfolgen. Im Ausführungsbeispiel ist eine sehr niedrige Zwischenfrequenzlage gewählt. Damit ist die Verwendung programmgesteuerter digitaler Signalverarbeitungsschaltkreise möglich. Bei PSK darf jedoch die Zwischenfrequenz 0 Hz nicht erreicht werden, da ein Pendeln um diese Nullinie zusätzliche Phasensprünge verursachen würde. Die Zwischenfrequenz ist hier mit 10 kHz so gewählt, daß auch bei größter Dopplerverschiebung (etwa 5 kHz) und möglichen Abweichungen des Referenzoszillators vom Sollwert das Signal einschließlich Modulation die Nullinie nicht erreicht.

Die Zwischenfrequenz wird im Empfangsmischer 12 in einer Stufe erreicht und im selektiven Verstärker 13 ausgefiltert. Die Mischfrequenz für den Empfangsmischer 12 wird in einem Frequenzvervielfacher 14 aus der Frequenz des quarzgesteuerten Referenzoszillators 15 durch Multiplikation mit einem Faktor K erzeugt.

Der Träger-Phasenregelkreis 20 ist als an sich bekannter Costas-Regelkreis ausgeführt. Er weist zwei Zweige A und B für das Inphase-Signal I bzw. das Quadratur-Signal Q auf. In einem spannungsgesteuerten Oszillator (voltage controlled oscillator, VCO) wird (in Zwischenfrequenzlage) der Träger in Frequenz und Phase nachgebildet. Dieses Signal wird einmal direkt (im Zweig A) und einmal in einem Phasenschieber 27 um 90 Grad gedreht (im Zweig B) in Synchrondemodulatoren 21A und 21B mit dem Ausgangssignal des Bandpasses 34 gemischt. Danach wird in Tiefpässen 22A und 22B das Inphase-Signal I bzw. das Quadratur-Signal Q gebildet. Das Inphase-Signal I enthält gleichzeitig im Vorzeichen die Daten D. Auch das Vorzeichen des Quadratur-Signals Q ändert sich mit den Daten D. Durch Multiplikation des Inphase-Signals I mit dem Quadratur-Signal Q in einem Multiplizierer 23 ergibt sich ein von den Daten D unabhängiges Signal, das, nach Filterung in einem Regeltiefpaß 24, dem Oszillator 26 als Regelgröße zugeführt wird. Damit wird das Inphase-Signal I auf maximale Amplitude geregelt.

In einem Summierkreis 25 wird dieser Regelgröße noch das Signal v der Regeleinrichtung 30 zugeführt. Damit wird eine Voreinstellung erreicht, die im wesentlichen die Dopplerverschiebung berücksichtigt.

Durch zwei Quadrierer 28A und 28B werden das Inphase-Signal I und das Quadratur-Signal Q quadriert und in einem nachfolgenden Summierkreis 29 wird die Summe dieser beiden Quadrate gebildet. Das Ergebnis ist die dem Betragsquadrat der Signalamplitude proportionale Größe, die als Regelgröße der Regeleinrichtung 30 zugeführt wird.

### Bezugszeichen

- A, B: Zweige
- D: Daten
- I: Inphase-Signal
- K: Faktor
- P: zusätzliche Regelgröße (Preset)
- Q: Quadratur-Signal
- v: Signal

- 10: Antenne
- 11: Vorverstärker, selektiv
- 12: Empfangsmischer
- 13: Verstärker, selektiv
- 14: Frequenzvervielfacher
- 15: Referenzoszillator, quarzgesteuert
- 20: Träger-Phasenregelkreis
- 21A, B: Synchrondemodulator
- 22A, B: Tiefpaß
- 23: Multiplizierer
- 24: Regeltiefpaß
- 25: Summierkreis
- 26: spannungsgesteuerter Oszillator
- 27: Phasenschieber
- 28A, B: Quadrierer
- 29: Summierkreis
- 30: Regeleinrichtung
- 32: Kode-Generator
- 33: Synchrondemodulator
- 34: Bandpaß

## Patentansprüche

1. Empfänger, insbesondere GPS-Empfänger, für Signale, die sendeseitig durch Amplituden- oder Phasenumtastung eines Trägers durch einen vorgegebenen Bandspreizungs-Kode entstehen, in dem Frequenz und Phase des Kodes in einem Kode-Phasenregelkreis (20, 30, 32, 33, 34) und Frequenz und Phase des Trägers in einem Träger-Phasenregelkreis (21A, 22A, 23, 24, 26) auf die empfangenen Frequenzen und Phasen geregelt werden, **dadurch** **gekennzeichnet**, daß eine zur Regelung von Frequenz und Phase im Kode-Regelkreis verwendete Fehlergröße (V) zur Regelgröße des Träger-Phasenregelkreises addiert (25) wird.

2. Empfänger nach Anspruch 1, dadurch gekennzeichnet, daß die Regelung von Frequenz und Phase des Trägers in Zwischenfrequenzlage erfolgt.

3. Empfänger nach Anspruch 2, dadurch gekennzeichnet, daß die Zwischenfrequenz so gewählt ist, daß sie bei maximal zulässiger Abweichung von ihrer Sollfrequenz gerade noch von Null verschieden ist.

4. Empfänger nach einem der Ansprüche 1 bis 3, dadurch gekennzeichnet, daß ein Kode-Phasenregelkreis (20, 30 ... 34) mit einem Synchrondemodulator (33) verwendet wird, daß das zur Synchrondemodulation verwendete Signal in einem Kode-Generator (32) erzeugt wird, der von einem Referenzoszillator (15) getaktet wird und daß Phase und Frequenz des Kode-Generators (32) durch einmalige bzw. laufende Phasenverschiebung aufgrund einer im Kode-Phasenregelkreis erzeugten Regelgröße verändert werden.

5. Empfänger nach Anspruch 4, dadurch gekennzeichnet, daß im Kode-Phasenregelkreis ein Signal (v) abgeleitet wird, das der Geschwindigkeit der Phasenverschiebung und damit der Frequenzabweichung proportional ist und daß dieses Signal die zur Regelgröße des Träger-Phasenregelkreises zu addierende Fehlergröße ist.

6. Empfänger nach einem der Ansprüche 1 bis 5, dadurch gekennzeichnet, daß die empfangenen Signale in einem Mischer (12) mit einem Signal gemischt werden, das in einem Frequenzvervielfacher (14) aus dem Signal eines Referenzoszillators (15) gewonnen wird, mit dem auch die Frequenz des Kodes verglichen wird.

7. Empfänger nach einem der Ansprüche 1 bis 6, dadurch gekennzeichnet, daß die Phasenregelkreise ganz (20) oder teilweise (20, 30) durch einen programmgesteuerten digitalen Signalverarbeitungsschaltkreis realisiert sind.

## Claims

1. A receiver, particularly a GPS receiver, for signals which are generated at the transmitting end by amplitude- or phase-shift keying a carrier using a predetermined bandspreading code, wherein the frequency and phase of the code are controlled in a code phase-locked loop (20, 30, 32, 33, 34), and the frequency and phase of the carrier are controlled in a carrier phase-locked loop (21A, 22A, 23, 24, 26), to synchronize with the received frequencies and phases, **characterized in** that an error quantity (V) used to control the frequency and phase in the code phase-locked loop is added (25) to the control quantity of the carrier phase-locked loop.

2. A receiver as claimed in claim 1, characterized in that the control of the frequency and phase of the carrier takes place in the intermediate-frequency range.

3. A receiver as claimed in claim 2, characterized in that the intermediate frequency is chosen to be just nonzero at the maximum permissible deviation from its desired value.

4. A receiver as claimed in any one of claims 1 to 3, characterized in that use is made of a code phase-locked loop (20, 30, ... 34) including a synchronous demodulator (33), that the signal used for synchronous demodulation is generated in a code generator (32) clocked by a reference oscillator (15), and that the phase and frequency of the code generator (32) are changed, respectively, by a single phase shift and by a continuous phase shift caused by a control quantity generated in the code phase-locked loop.

5. A receiver as claimed in claim 4, characterized in that in the code phase-locked loop, a signal (V) is derived which is proportional to the speed of the phase shift and, thus, the frequency deviation, and that said signal is the error quantity to be added to the control quantity of the carrier phase-locked loop.

6. A receiver as claimed in any one of claims 1 to 5, characterized in that in a mixer (12), the received signals are mixed with a signal derived in a frequency multiplier (14) from the signal of a reference oscillator (15), which is also compared with the frequency of the code.

7. A receiver as claimed in any one of claims 1 to 6, characterized in that the phase-locked loops are implemented wholly (20) or in part (20, 30) with a program-controlled digital signal-processing circuit.

## Revendications

1. Récepteur, en particulier récepteur du système de positionnement général à réseau de satellites GPS, pour signaux qui sont constitués, du côté émission, par modification, par sauts d'amplitude ou par déplacement de phase, d'une porteuse au moyen d'un code d'étalement du spectre prédéterminé, dans lequel la fréquence et la phase du code sont réglées sur les fréquences et les phases reçues dans un circuit de régulation en boucle à phase asservie (20,30, 32, 33, 34) du code et la fréquence et la phase de la porteuse le sont dans un circuit de régulation en boucle en phase asservie (21A, 22A, 23, 24, 26) de la porteuse, caractérisé par le fait qu'à la grandeur réglée du circuit de régulation en boucle à phase asservie de la porteuse on ajoute (25) un signal de correction (V) employé pour la régulationde la fréquence et de la phase dans le circuit de régulation du code.

2. Récepteur selon la revendication 1, caractérisé par le fait que la régulation de la fréquence et de la phase de la porteuse se fait en position de fréquence intermédiaire.

3. Récepteur selon la revendication 2, caractérisé par le fait que l'on choisit la fréquence intermédiaire de façon que pour un écart maximal autorisé par rapport à sa fréquence prescrite, elle soit encore juste différente de zéro.

4. Récepteur selon l'une des revendications 1 à 3, caractérisé par le fait que l'on emploie un circuit de régulation en boucle à phase asservie (20, 30 ... 34) du code avec un démodulateur synchrone (33), par le fait que l'on produit le signal employé pour la démodulation synchrone dans un générateur de code (32) qui est cadencé par un oscillateur de référence (15) et par le fait que la phase et la fréquence du générateur de code (32) sont modifiées par un décalage de phase unique ou permanent sur la base d'une grandeur réglée produite dans le circuit de régulation en boucle à phase asservie du code.

5. Récepteur selon la revendication 4, caractérisé par le fait que l'on dérive dans le circuit de régulation en boucle à phase asservie du code un signal (v) qui est proportionnel à la vitesse du décalage de phase et donc à l'écart de fréquence et par le fait que ce signal est le signal de correction à ajouter à la grandeur réglée du circuit de régulation en boucle à phase asservie de la porteuse.

6. Récepteur selon l'une des revendications 1 à 5, caractérisé par le fait que dans un mélangeur (12) on mélange les signaux reçus avec un signal qui s'obtient dans un multiplicateur de fréquence (14) à partir du signal d'un oscillateur de référence (15), avec lequel la fréquence du code est également comparée.

7. Récepteur selon l'une des revendications 1 à 6, caractérisé par le fait que les circuits de régulation en boucle à phase asservie sont réalisés totalement (20) ou partiellement (20, 30) par un circuit de traitement numérique des signaux commandés par programmation.
